# FASCICULE DE BREVET EUROPEEN

(11) **EP 0 707 237 B1**
(45) Date de publication et mention de la délivrance du brevet: **10.03.1999**
(21) Numéro de dépôt: 95402238.0
(22) Date de dépôt: 06.10.1995
(51) Int. Cl.: G03F 7/20, H01J 9/02

(54) **Procédé de formation de trous dans une couche de résine photosensible, application à la fabrication de sources d'électrons à cathodes emissives a micropointes et d'écrans plats de visualisation**
Verfahren zur Herstellung von Löchern in Photoresistschichten, Anwendung für die Herstellung von Elektronenquelle mit Mikrospitzenemissionskathoden und flachen Bildschirmen
Process for the fabrication of holes in photoresist layers, use for the fabrication of electron sources comprising emissive cathodes with microtips and flat display screens

(30) Priorité: 10.10.1994 FR 9412065
(43) Date de publication de la demande: 17.04.1996
(73) Titulaire: COMMISSARIAT A L'ENERGIE ATOMIQUE, 75015 Paris Cédex 15 (FR)
(72) Inventeur: Ida, Michel, F-38340 Voreppe (FR); Montmayeuil, Brigitte, F-38190 Bruignoud (FR)
(74) Mandataire: Dubois-Chabert, Guy

(56) Documents cités:
- DE-A- 3 821 268
- GB-A- 2 253 925
- US-A- 4 668 080
- PATENT ABSTRACTS OF JAPAN vol. 7, no. 30 (P-173) 1175 05 Février 1983 & JP-A-57 181 549 (MASTAKE SATOU) 09 Novembre 1982
- PATENT ABSTRACTS OF JAPAN vol. 7, no. 75 (P-187) 29 Mars 1983 & JP-A-58 004 148 (SATOU MASATAKE)

## Description

### DOMAINE TECHNIQUE

La présente invention concerne un procédé de formation de trous dans une couche de résine photosensible.

Elle s'applique notamment à la fabrication de sources d'électrons à cathodes émissives à micropointes qui sont particulièrement utilisables pour la fabrication de dispositifs de visualisation par cathodoluminescence excitée par émission de champ.

L'invention permet par exemple de fabriquer des écrans plats à micropointes de grande taille, par exemple supérieure à 14 pouces (environ 35 cm), et même des écrans plats à micropointes dont la superficie est voisine de 1 m².

Bien entendu des écrans de taille nettement plus grande peuvent être élaborés grâce à la présente invention.

L'invention s'applique aussi à la fabrication de couches anti-reflets gravées, de capteurs pour microsystèmes et de couches anti-reflets vis-à-vis des ondes radar.

### ETAT DE LA TECHNIQUE ANTERIEURE

Des sources d'électrons à cathodes émissives à micropointes et leurs procédés de fabrication sont décrits par exemple dans les documents suivants auxquels on se reportera :
(1) FR-A-2 593 953 (voir aussi EP-A-0 234 989 et également US-A-4 857 161)
(2) FR-A-2 687 839 (voir aussi EP-A-0 558 393)

Pour faciliter la compréhension du problème technique résolu par la présente invention, on décrit ci-après un exemple connu de procédé de fabrication d'une source d'électrons à cathodes émissives à micropointes.

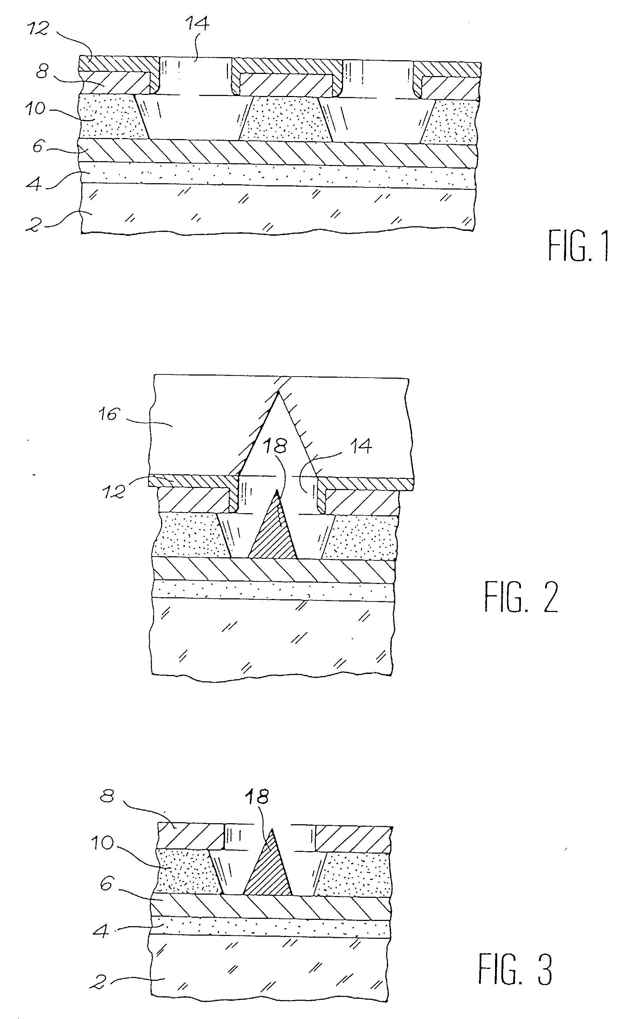

On se référera aux figures 1 à 3 des dessins annexés.

La figure 1 montre une structure déjà élaborée, comprenant, sur un substrat 2 surmonté d'un isolant 4, un système de conducteurs cathodiques 6 et de grilles 8 superposés sous forme croisée, avec un isolant intermédiaire 10, et une couche 12, par exemple en nickel, déposée en surface pour servir de masque lors des opérations de réalisation des micropointes.

Cette couche 12 de nickel, les grilles 8 et l'isolant 10 sont percés de trous 14, au fond desquels il s'agit de déposer ultérieurement les micropointes constituées d'un métal conducteur en liaison électrique avec les conducteurs cathodiques 6.

La réalisation des micropointes va maintenant être expliquée en faisant référence à la figure 2.

On commence d'abord par effectuer par exemple le dépôt d'une couche en molybdène 16 sur l'ensemble de la structure.

Cette couche 16 présente une épaisseur d'environ 1,8 µm.

Elle est déposée sous incidence normale par rapport à la surface de la structure.

Cette technique de dépôt permet d'obtenir des cônes 18 en molybdène logés dans les trous 14 et ayant une hauteur de 1,2 à 1,5 µm.

Ces cônes constituent les micropointes émettrices d'électrons.

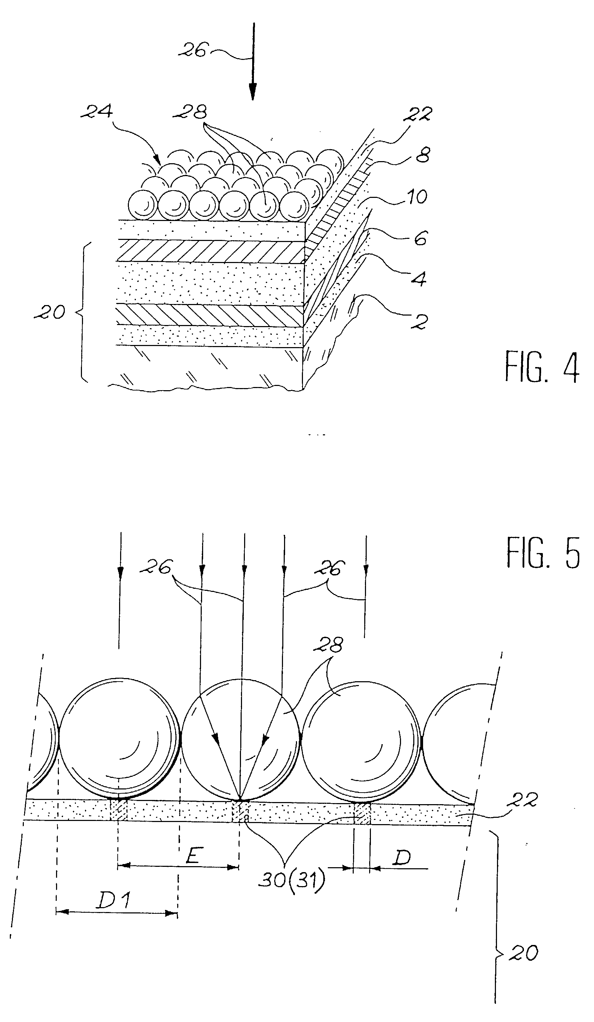

On réalise ensuite la dissolution sélective de la couche de nickel 12 par un procédé électrochimique, de façon à dégager, comme on le voit sur la figure 3, les grilles perforées 8, par exemple en niobium, et à faire apparaître les micropointes 18 émettrices d'électrons.

A quelques variantes technologiques près, la méthode connue ainsi décrite en se référant aux figures 1, 2 et 3 est toujours celle que l'on a appliqué jusqu'à ce jour pour réaliser les micropointes des sources d'électrons à cathodes émissives à micropointes.

Pour que la taille et le positionnement des micropointes 18 soient corrects il faut bien entendu maîtriser parfaitement la taille des trous réalisés dans les grilles 8 et dans l'isolant 10.

Le problème est donc le suivant :

Il s'agit de réaliser, sur toutes les surfaces devant recevoir des micropointes, des trous dont le diamètre moyen est par exemple de 1,3 µm ou moins.

Les méthodes actuellement utilisées pour ce faire sont des procédés de photolithogravure utilisant la projection directe ou la photorépétition d'un motif élémentaire reproduit sur toutes ces surfaces.

Dans le cas de sources d'électrons de grande taille, supérieure à 14 pouces (environ 35 cm) par exemple, ces procédés deviennent vite très contraignants.

La projection directe nécessite la réalisation d'un masque à l'échelle 1 de grande taille, comportant des motifs submicroniques.

Ce masque est difficilement réalisable au dessus de 35 cm (14 pouces) de diagonale.

En ce qui concerne la photorépétition, on utilise un masque de petite taille, cette taille étant déterminée par la résolution des motifs utilisés.

Pour une résolution de 1 µm, on utilise par exemple un masque de 20 à 50 mm de côté, ce qui oblige à répéter un grand nombre de fois l'opération d'insolation qui est nécessaire à la photolithogravure, pour couvrir la surface totale de la source d'électrons.

Ces deux méthodes (l'une utilisant la projection directe et l'autre la photorépétition) sont donc difficilement applicables à la réalisation de sources d'électrons de grande taille.

### EXPOSE DE L'INVENTION

La présente invention permet de réaliser des trous de façon beaucoup plus simple que les procédés connus qui ont été mentionnés plus haut.

La présente invention concerne un procédé très simple de formation de trous dans une couche de résine photosensible.

L'invention permet de former des trous dont le diamètre peut être de l'ordre de 1 µm ou inférieur à 1 µm, sur de petites surfaces ou sur de grandes surfaces.

L'invention permet d'insoler une couche de résine photosensible en des points de celle-ci, qui correspondent aux emplacements des trous à former dans la résine.

Cette résine, une fois développée (c'est-à-dire après dissolution des zones insolées), servira de masque pour former des trous dans une structure sur laquelle se trouve la couche de résine.

Par exemple, en considérant la structure décrite en faisant référence aux figures 1 à 3, la couche de résine servira, après développement, à graver les grilles 8 et l'isolant intermédiaire 10.

De façon précise, la présente invention a pour objet un procédé de formation de trous dans une couche de résine photosensible positive, au moyen d'une lumière d'insolation, ce procédé étant caractérisé en ce qu'il comprend les étapes suivantes :
- on forme une monocouche de billes transparentes à cette lumière d'insolation et en contact direct avec la couche de résine,
- on insole cette couche de résine par la lumière d'insolation, à travers la monocouche de billes, chaque bille concentrant cette lumière au point de contact de cette bille avec la couche de résine sur laquelle elle est posée et provoquant ainsi l'insolation d'une zone de cette couche de résine, la lumière d'insolation formant un faisceau parallèle, collimaté et d'intensité lumineuse constante sur toute la monocouche de billes, et
- on développe la couche de résine ainsi insolée, d'où la formation des trous dans cette couche, à la place des zones insolées.

Un premier avantage du procédé objet de la présente invention réside dans la grande simplicité de ce procédé vis-à-vis des procédés classiques de photolithogravure.

En effet, le procédé objet de l'invention n'utilise pas de masque particulier et ne nécessite pas de passer par des étapes d'alignement précis.

Un deuxième avantage de ce procédé réside dans la possibilité de traiter de grandes surfaces conformément à l'invention et donc de pouvoir réaliser des sources d'électrons à micropointes de grand format.

En effet, pour traiter une surface conformément à l'invention, il suffit d'étaler sur celle-ci une résine photosensible et, après séchage de cette dernière, de couvrir de billes cette surface, quelles que soient les dimensions de la surface considérée.

D'autres avantages de l'invention seront donnés plus loin.

Dans la présente invention, les billes peuvent être jointives ou, au contraire, non jointives et, dans ce cas, leur répartition peut être aléatoire.

Selon un premier mode de mise en oeuvre particulier du procédé objet de l'invention, la monocouche de billes est formée en déposant ces billes à la surface de la couche de résine photosensible.

Dans ce cas, les billes peuvent être déposées par centrifugation ou par pulvérisation ou par toute méthode d'entraînement laminaire des billes en phase liquide, à la surface de la couche de résine photosensible ou par toute autre technique d'étalement de billes.

Les billes peuvent être enlevées de la surface de la couche de résine photosensible avant le développement de cette couche de résine (mais après l'insolation de celle-ci).

Dans ce cas, les billes peuvent être enlevées par entraînement au moyen d'un liquide ou dans un bain soumis à des ultrasons.

En variante, les billes sont laissées sur la couche de résine, jusqu'au développement de celle-ci, et sont alors entraînées dans le bain de développement et peuvent ensuite être récupérées par filtrage de ce bain.

Selon un deuxième mode de mise en oeuvre particulier du procédé objet de l'invention, la monocouche de billes est formée en maintenant ces billes sur un support transparent à la lumière d'insolation et en appliquant les billes ainsi maintenues contre la surface de la couche de résine photosensible.

Les billes peuvent être maintenues sur le support au moyen d'un liant ou de forces électrostatiques.

Pour la mise en oeuvre de la présente invention, on peut utiliser par exemple des billes dont le diamètre est de l'ordre de 1 µm à 10 µm.

La présente invention concerne aussi un procédé de fabrication d'une source d'électrons à cathodes émissives à micropointes, procédé selon lequel :
- on forme une structure comprenant des conducteurs cathodiques sur un substrat, une couche électriquement isolante sur ces conducteurs cathodiques, et, sur cette couche électriquement isolante, des grilles qui font un angle avec les conducteurs cathodiques,
- dans les domaines où les grilles croisent les conducteurs cathodiques, on forme des trous à travers les grilles et la couche isolante, et
- on forme des micropointes en matériau émetteur d'électrons dans ces trous, sur les conducteurs cathodiques,
ce procédé étant caractérisé en ce que ces trous sont obtenus en formant une couche de résine photosensible positive à la surface de la structure, en formant des trous dans la couche de résine conformément au procédé de formation de trous objet de l'invention, et en gravant les grilles et la couche isolante à travers ces trous formés dans la couche de résine.

Cette dernière est donc utilisée comme un masque pour créer dans la structure sous-jacente les trous destinés au logement des micropointes.

On pourra avantageusement réserver, à l'aide d'un masque écran opaque à la lumière d'insolation, des régions dans lesquelles ne sont pas formés des trous. Cet écran sera placé entre la source de lumière d'insolation et la monocouche de billes.

### BREVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1 à 3, déjà décrites, illustrent de façon schématique et partielle un procédé connu de fabrication d'une source d'électrons à cathodes émissives à micropointes,
- la figure 4 est une vue schématique et partielle d'une monocouche de billes jointives permettant la mise en oeuvre d'un procédé conforme à l'invention,
- la figure 5 illustre schématiquement ce procédé conforme à l'invention,
- la figure 6 illustre schématiquement un autre procédé conforme à l'invention, utilisant une monocouche de billes qui ne sont pas jointives, et
- la figure 7 illustre schématiquement un autre procédé conforme à l'invention, utilisant une monocouche de billes qui est formée sur un support.

### EXPOSE DETAILLE DE MODES DE REALISATION PARTICULIERS

La figure 4 montre de façon schématique et partielle la structure dont il a été question dans la description des figures 1 à 3 et qui comprend le substrat 2, l'isolant 4, les conducteurs cathodiques 6, les grilles 8 et l'isolant intermédiaire 10.

On se propose de faire des trous dans les grilles 8 et l'isolant intermédiaire 10 grâce à un procédé conforme à la présente invention.

Pour faire ces trous, on dépose sur la surface de la structure, qui porte la référence 20 sur la figure 4, une couche 22 de résine photosensible positive.

On dépose ensuite, sur la surface de cette couche de résine 22, une monocouche 24 de billes qui sont transparentes à la lumière 26 utilisée pour insoler la résine.

On insole cette couche de résine par cette lumière 26, à travers la couche de billes 24 et perpendiculairement à la couche de résine 22.

Cette lumière 26 forme un faisceau lumineux parallèle, collimaté et d'intensité lumineuse constante sur toute la surface de la monocouche de billes, ce faisceau provenant d'une source lumineuse non représentée.

Comme on le voit sur la figure 5, chacune des billes 28 est prévue pour concentrer cette lumière au point de contact de cette bille avec la couche de résine 22 et provoque ainsi l'insolation d'une zone 30 de cette couche de résine qui se trouve au point de contact entre la bille et cette couche de résine.

On enlève ensuite les billes de la surface de la structure 20 et on développe la couche de résine ainsi insolée (en d'autres termes, on dissout les zones de résine insolées), d'où la formation de trous 31 dans cette couche de résine, à la place des zones insolées 30.

On pourrait aussi laisser les billes sur la couche de résine, développer la couche de résine ainsi insolée et récupérer les billes par filtrage du solvant ayant servi à dissoudre les zones insolées.

Pour que la résine puisse être insolée dans toute son épaisseur au niveau des zones 30, il faut que cette épaisseur soit faible, de l'ordre de grandeur du diamètre de la tache lumineuse correspondante, par exemple 1 µm.

L'homme du métier peut choisir, pour les billes, la taille et l'indice de réfraction aptes à fournir une tache lumineuse de diamètre approprié.

On utilise par exemple des billes en silice pour une lumière d'insolation qui se trouve dans le proche ultraviolet.

Bien entendu, on choisit une résine dont la vitesse d'attaque, en fonction de la dose de lumière d'insolation reçue par cette résine, permet de s'affranchir des effets dus à la lumière d'insolation parasite qui pourrait passer entre les billes.

En considérant la figure 5, on notera qu'un avantage supplémentaire du procédé objet de l'invention réside dans le fait que le diamètre D de la tache lumineuse induite par chaque bille est facilement ajustable à des valeurs de l'ordre de 1 µm ou inférieure à 1 µm en choisissant un diamètre D1 convenable pour les billes ainsi que le temps d'insolation.

Les billes transparentes à la lumière d'insolation concentrent le faisceau lumineux au point de contact de chaque bille de verre et de la couche de résine photosensible. La surface de la tache lumineuse qui en résulte n'est pas éclairée de façon homogène. L'intensité lumineuse qu'elle reçoit est maximale au centre de la tache et décroît en s'éloignant vers les bords. Ainsi, en jouant sur le temps d'insolation, on peut ajuster le diamètre de la zone insolée sur toute l'épaisseur de la couche de résine photosensible et ainsi ajuster le diamètre des trous.

Moins on insole la couche de résine à travers les billes, plus la surface de la couche de résine qui est insolée (et qui est donc solubilisable) est petite et plus la taille des trous formés dans la résine et donc la taille des trous formés à travers les précédents dans les grilles et l'isolant intermédiaire sont petites.

La diminution de la taille des trous formés dans les grilles et l'isolant intermédiaire permet, de façon avantageuse, la diminution de la tension de commande des micropointes.

Dans le cas des figures 4 et 5, les billes déposées à la surface de la structure 20 sont jointives.

Dans ce cas, un avantage supplémentaire du procédé objet de l'invention réside dans le fait que le diamètre D1 des billes 28 détermine l'espacement E entre les centres des trous formés dans la couche de résine.

On choisit par exemple des billes calibrées dont les diamètres respectifs sont compris dans l'intervalle allant de 1µm à 10 µm. On peut alors parler de micro-billes.

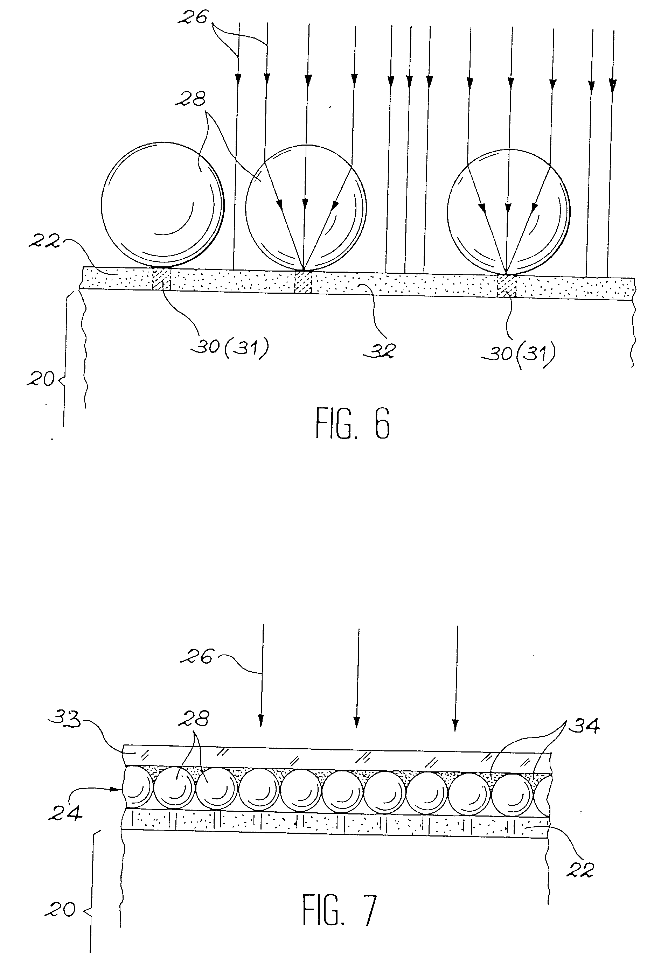

La figure 6 illustre schématiquement la possibilité de déposer à la surface de la couche de résine 22 une monocouche de billes qui ne sont pas jointives et dont la répartition peut être aléatoire.

Pour obtenir une telle monocouche de billes non jointives, on peut utiliser par exemple la méthode suivante pour déposer ces billes à la surface de la couche photosensible : pulvérisation des billes en solution dans un mélange d'eau et d'éthanol.

Cette possibilité d'utiliser des billes non jointives constitue un autre avantage de l'invention puisque la dose d'insolation est beaucoup plus forte au point de concentration (zone insolée 30) qu'autour des billes non jointives, c'est-à-dire dans les zones 32 de la figure 6.

On explique ci-après comment former les trous 14 dans les grilles 8 et l'isolant intermédiaire 10 dont il a été question dans la description des figures 1 à 4, en utilisant un procédé conforme à la présente invention.

Plus précisément, on souhaite former une source à cathodes émissives à micropointes et pour ce faire, on commence par former sur le substrat 2 l'isolant 4, les conducteurs cathodiques 6, l'isolant intermédiaire 10 et les grilles 8 dont il a été question plus haut.

Dans le cas où cela est nécessaire, on masque ensuite, en une ou plusieurs étapes, les zones où l'on ne veut pas réaliser de trous.

Pour ceci, on se rapportera par exemple au document (2) mentionné plus haut.

Ensuite, conformément à la présente invention, on étale une couche de résine photosensible 22 sur toute la surface de la structure 20 obtenue.

L'épaisseur de la couche de résine 22 vaut par exemple 1,2 µm et son indice de réfraction 1,7.

On durcit ensuite cette couche de résine par étuvage.

On étale ensuite une monocouche de billes de verre 24 sur la surface de cette couche de résine 22 par centrifugation ou par pulvérisation.

Les billes ont par exemple un diamètre de 4 µm et un indice de réfraction de 1,5.

On insole ensuite la résine à travers cette monocouche de billes au moyen d'une lumière de longueur d'onde égale à 500 nm.

Ensuite, on enlève les billes de la couche de résine ainsi insolée puis on développe la résine, c'est-à-dire qu'on dissout cette résine dans les zones insolées.

On obtient ainsi des trous à la place de ces zones insolées.

On précise que pour retirer les billes de la couche de résine, il suffit d'utiliser un liquide que l'on fait couler sur cette couche de résine et qui entraîne les billes avec lui.

On peut utiliser des ultra-sons pour faciliter le décollement des billes.

En tant que liquide d'entraînement on utilise par exemple de l'eau désionisée.

Ce liquide peut ensuite être filtré pour récupérer les billes.

On pourrait ne pas enlever les billes de la couche de résine avant son développement.

Les billes seraient alors éliminées, lors de la dissolution de la résine dans les zones insolées, et récupérées par filtrage du solvant servant au développement.

Ayant ainsi obtenu les trous dans la couche de résine, on poursuit le procédé de fabrication de la source d'électrons à cathodes émissives à micropointes de la façon suivante.

On grave, à travers les trous formés dans la couche de résine, les grilles 8 et l'isolant intermédiaire 10 pour y former les trous 14 (figure 1).

On enlève ensuite la couche de résine.

Ensuite, on dépose sous incidence rasante la couche de nickel 12 sur la structure obtenue.

On dépose ensuite la couche de molybdène 16, d'où la formation des micropointes 18, et l'on enlève la couche de nickel 12 et la couche de molybdène 16.

Un autre procédé conforme à la présente invention est schématiquement illustré par la figure 7.

Selon cet autre procédé, les billes 28 ne sont pas directement déposées sur la surface de la couche de résine photosensible 22.

Ces billes 28 sont maintenues sur un support plan 33 qui est transparent à la lumière d'insolation.

On obtient ainsi encore une monocouche de billes que l'on applique sur la couche de résine photosensible 22.

L'irradiation de celle-ci se fait alors à travers le support transparent 33 et les billes 28.

Pour maintenir les billes 28 sur le support 33, on peut utiliser un liant 34 par exemple constitué par un polymère tel que le polyméthylmétacrylate ou un gel tel que la silice colloïdale.

Pour maintenir les billes sur le support 33 au moyen du liant 34, on peut procéder par exemple de la façon suivante : centrifugation d'un mélange de billes et de liant à la surface du support 33.

En variante, pour maintenir les billes sur le support 33, on mélange les billes à un liquide tel qu'un mélange d'eau désionisée et d'éthanol ou tel que l'éthanol pur par exemple.

Ensuite, on étale une couche de ce liquide sur le support 33 puis on fait évaporer le liquide et l'on obtient alors la monocouche de billes sur le support 33.

Dans ce cas, les billes sont maintenues par des forces électrostatiques sur ce support 33.

On utilise par exemple un support 33 en silice pour une lumière d'insolation qui se trouve dans le proche ultraviolet.

## Revendications

1. Procédé de formation de trous dans une couche de résine photosensible positive (22), au moyen d'une lumière d'insolation, ce procédé étant caractérisé en ce qu'il comprend les étapes suivantes :
- on forme une monocouche de billes transparentes à cette lumière d'insolation et en contact direct avec la couche de résine,
- on insole cette couche de résine par la lumière d'insolation (26), à travers la monocouche (24) de billes (28), chaque bille concentrant cette lumière au point de contact de cette bille avec la couche de résine sur laquelle elle est posée et provoquant ainsi l'insolation d'une zone (30) de cette couche de résine, la lumière d'insolation formant un faisceau parallèle, collimaté et d'intensité lumineuse constante sur toute la monocouche de billes, et
- on développe la couche de résine ainsi insolée, d'où la formation des trous dans cette couche, à la place des zones insolées.

2. Procédé selon la revendication 1, caractérisé en ce que les billes (28) sont jointives.

3. Procédé selon la revendication 1, caractérisé en ce que les billes (28) ne sont pas jointives.

4. Procédé selon la revendication 3, caractérisé en ce que la répartition des billes non jointives est aléatoire.

5. Procédé selon l'une quelconque des revendications 1 à 4, caractérisé en ce que la monocouche (24) de billes est formée en déposant ces billes à la surface de la couche de résine photosensible (22).

6. Procédé selon la revendication 5, caractérisé en ce que les billes (28) sont déposées par centrifugation à la surface de la couche de résine photosensible (22).

7. Procédé selon la revendication 5, caractérisé en ce que les billes (28) sont déposées par pulvérisation à la surface de la couche de résine photosensible (22).

8. Procédé selon l'une quelconque des revendications 5 à 7, caractérisé en ce que les billes (28) sont enlevées de la surface de la couche de résine photosensible (22) avant le développement de celle-ci.

9. Procédé selon les revendications 8, caractérisé en ce que les billes (28) sont enlevées de la couche de résine photosensible (22) par entraînement au moyen d'un liquide ou dans un bain soumis à des ultrasons.

10. Procédé selon l'une quelconque des revendications 5 à 7, caractérisé en ce que les billes (28) sont laissées sur la couche de résine jusqu'au développement de celle-ci, et sont ensuite entraînées dans le bain de développement de cette couche.

11. Procédé selon l'une quelconque des revendications 1 à 4, caractérisé en ce que la monocouche (24) de billes est formée en maintenant ces billes sur un support (33) transparent à la lumière d'insolation (26) et en appliquant les billes ainsi maintenues contre la surface de la couche de résine photosensible (22).

12. Procédé selon la revendication 11, caractérisé en ce que les billes (28) sont maintenues sur le support (33) au moyen d'un liant ou de forces électrostatiques.

13. Procédé selon l'une quelconque des revendications 1 à 12, caractérisé en ce que les billes (28) ont un diamètre de l'ordre de 1 µm à 10 µm.

14. Procédé de fabrication d'une source d'électrons à cathodes émissives à micropointes, procédé selon lequel :
- on forme une structure (20) comprenant des conducteurs cathodiques (6) sur un substrat (2), une couche électriquement isolante (10) sur ces conducteurs cathodiques, et, sur cette couche électriquement isolante, des grilles (8) qui font un angle avec les conducteurs cathodiques,
- dans les domaines où les grilles croisent les conducteurs cathodiques, on forme des trous (14) à travers les grilles et la couche isolante, et
- on forme des micropointes (18) en matériau émetteur d'électrons dans ces trous, sur les conducteurs cathodiques,
ce procédé étant caractérisé en ce que ces trous (14) sont obtenus en formant une couche de résine photosensible positive (22) à la surface de la structure (20), en formant des trous dans la couche de résine (22) conformément au procédé selon l'une quelconque des revendications 1 à 13, et en gravant les grilles et la couche isolante à travers ces trous formés dans la couche de résine.

15. Ecran plat utilisant la source d'électrons obtenue par le procédé selon la revendication 14.

## Patentansprüche

1. Verfahren zur Bildung von Löchern in einer Positivresistschicht (22) mittels eines Belichtungslichts, wobei dieses Verfahren
**dadurch gekennzeichnet** ist, daß es die folgenden Schritte umfaßt:
- Bilden einer einlagigen Schicht aus Kugeln, durchlässig für dieses Belichtungslicht und in direktem Kontakt mit der Resistschicht,
- Belichten dieser Resistschicht durch die einlagige Schicht (24) aus Kugeln (28) hindurch, mit dem Belichtungslicht (26), wobei jede Kugel dieses Licht in ihrem Kontaktpunkt mit der Resistschicht, auf der sie ruht, konzentriert und somit die Belichtung einer Zone (30) dieser Resistschicht verursacht und das Belichtungslicht dabei ein paralleles Bündel bildet, kollimatiert und mit konstanter Lichtintensität über die gesamte einlagige Kugelschicht, und
- Entwickeln der derart belichteten Resistschicht, was an den belichteten Stellen zur Bildung der Löcher in dieser Schicht führt.

2. Verfahren nach Anspruch 1, dadurch gekennzeichnet, daß die Kugeln (28) aneinanderstoßen.

3. Verfahren nach Anspruch 1, dadurch gekennzeichnet, daß die Kugeln (28) nicht aneinanderstoßen.

4. Verfahren nach Anspruch 3, dadurch gekennzeichnet, daß die Verteilung der nichtaneinanderstoßenden Kugeln zufällig ist.

5. Verfahren nach einem der Ansprüche 1 bis 4, dadurch gekennzeichnet, daß die einlagige Schicht (24) aus Kugeln gebildet wird, indem man diese Kugeln an der Oberfläche der Photoresistschicht (22) abscheidet bzw. erzeugt.

6. Verfahren nach Anspruch 5, dadurch gekennzeichnet, daß die Kugeln (28) durch Schleudern an der Oberfläche der Photoresistschicht (22) erzeugt werden.

7. Verfahren nach Anspruch5, dadurch gekennzeichnet, daß die Kugeln (28) durch Sputtern an der Oberfläche der Photoresistschicht (22) erzeugt werden.

8. Verfahren nach einem der Ansprüche 5 bis 7, dadurch gekennzeichnet, daß die Kugeln (28) von der Oberfläche der Photoresistschicht (22) entfernt werden, ehe diese entwickelt wird.

9. Verfahren nach Anspruch 8, dadurch gekennzeichnet, daß die Kugeln (28) von der Oberfläche der Photoresistschicht (22) entfernt werden, indem sie durch eine Flüssigkeit weggespült werden oder in einem Bad Ultraschallwellen ausgesetzt werden.

10. Verfahren nach einem der Ansprüche 5 bis 7, dadurch gekennzeichnet, daß die Kugeln (28) auf der Resistschicht bleiben, bis diese entwickelt wird, und anschließend von dem Entwicklungsbad dieser Schicht weggespült werden.

11. Verfahren nach einem der Ansprüche 1 bis 4, dadurch gekennzeichnet, daß die einlagige Kugelschicht (24) gebildet wird, indem diese Kugeln auf einem für das Belichtungslicht durchlässigen Träger (33) erzeugt und festgehalten werden und die derart durch den Träger festgehaltenen Kugeln auf der Oberfläche der Photoresistschicht (22) angebracht werden.

12. Verfahren nach Anspruch 11, dadurch gekennzeichnet, daß die Kugeln (28) auf dem Träger (33) durch ein Bindemittel oder durch elektrostatische Kräfte festgehalten werden.

13. Verfahren nach einem der Ansprüche 1 bis 12, dadurch gekennzeichnet, daß die Kugeln (28) einen Durchmesser in der Größenordnung von 1µm bis 10µm haben.

14. Herstellungsverfahren einer Elektronenquelle mit Mikrospitzenemissionskathoden, folgende Schritte umfassend:
- Bilden einer Struktur (20) mit Kathodenleitern (6) auf einem Substrat (2), einer elektrisch isolierenden Schicht (10) auf diesen Kathodenleitern und, auf dieser elektrisch isolierenden Schicht, Gitter (8), die mit den Kathodenleitern einen Winkel bilden,
- Bilden der Löcher (14) durch die Gitter und die isolierende Schicht hindurch in den Bereichen, wo die Gitter die Kathodenleiter überkreuzen, und
- Bilden der Mikrospitzen (18) aus elektronenemittierendem Material in diesen Löchern, auf den Kathodenleitern,
**dadurch gekennzeichnet,** daß diese Löcher (14) hergestellt werden, indem man eine Positivresistschicht (22) an der Oberfläche der Struktur (20) bildet, in dieser Schicht (22) Löcher bildet nach einem der Ansprüche 1 bis 13 und die Gitter und die Isolierschicht durch diese in der Resistschicht gebildeten Löcher hindurch ätzt.

15. Flachbildschirm mit Elektronenquelle, hergestellt nach dem Verfahren gemäß Anspruch 14.

## Claims

1. Process for the formation of holes in a positive, photosensitive resin layer (22) by means of an exposure light (26), said process being characterized in that it comprises the following stages:
- formation takes place of a monolayer (24) of balls (28) transparent to said exposure light and in direct contact with the resin layer,
- the resin layer is exposed by the exposure light through the monolayer of balls, each ball concentrating said light at the contact point of said ball with the resin layer on which it is placed, thus bringing about the exposure of an area (30) of said resin layer, the exposure light forming a parallel, collimated beam with a constant light intensity over the entire monolayer of balls and
- the thus exposed resin layer is developed leading to the formation of holes in said layer at the location of the exposed areas.

2. Process according to claim 1, characterized in that the balls (28) are contiguous.

3. Process according to claim 1, characterized in that the balls (28) are non-contiguous.

4. Process according to claim 3, characterized in that the non-contiguous balls have a random distribution.

5. Process according to any one of the claims 1 to 4, characterized in that the monolayer (24) of balls is formed by depositing said balls on the surface of the photosensitive resin layer (22).

6. Process according to claim 5, characterized in that the balls (28) are deposited by centrifuging on the surface of the photosensitive resin layer (22).

7. Process according to claim 5, characterized in that the balls (28) are deposited by spraying on the surface of the photosensitive resin layer (22).

8. Process according to any one of the claims 5 to 7, characterized in that the balls (28) are removed from the surface of the photosensitive resin layer (22) following the development of the latter.

9. Process according to claim 8, characterized in that the balls (28) are removed from the photosensitive resin layer (22) by entrainment by means of a liquid or in a bath exposed to ultrasonic action.

10. Process according to any one of the claims 5 to 7, characterized in that the balls (28) are left on the resin layer until the latter is developed and are then entrained into the development bath of said layer.

11. Process according to any one of the claims 1 to 4, characterized in that the monolayer (24) of balls is formed whilst maintaining said balls on a support (33) transparent to the exposure light (26) and by applying the thus maintained balls to the surface of the photosensitive resin layer (22).

12. Process according to claim 11, characterized in that the balls (28) are maintained on the support (33) by means of a binder or electrostatic forces.

13. Process according to any one of the claims 1 to 12, characterized in that the balls (28) have a diameter of approximately 1 to 10 µm.

14. Process for the production of an electron source having emissive cathodes with microtips, according to which:
- a structure (20) is formed comprising cathode conductors (6) on a substrate (2), an electrically insulating layer (10) on said cathode conductors and, on said electrically insulating layer, grids (8) forming an angle with the cathode conductors,
- in the areas where the grids intersect the cathode conductors, holes (14) are formed through the grids and the insulating layer and
- electron-emitting material microtips (18) are formed in these holes on the cathode conductors,
said process being characterized in that the holes (14) are obtained by forming a positive, photosensitive resin layer (22) on the surface of the structure (20), by forming holes in the resin layer (22) according to the hole formation process according to the invention and by etching the grids and the insulating layer through the holes formed in the resin layer.

15. Flat screen using the electron source obtained by the process according to claim 14.
